# EUROPÄISCHE PATENTSCHRIFT

(11) **EP 3 627 637 B1**
(45) Veröffentlichungstag und Bekanntmachung des Hinweises auf die Patenterteilung: **21.04.2021**
(21) Anmeldenummer: 18195203.7
(22) Anmeldetag: 18.09.2018
(51) Int. Cl.: H01S 5/00, H01S 5/022, G02B 7/00, G02B 7/02, G02B 27/62, H01S 5/02, H01S 5/024, H01S 5/065, G02B 19/00

(54) **VERFAHREN ZUM POSITIONSOPTIMIERTEN VERBINDEN EINER KOLLIMATIONSOPTIK MIT EINER MULTIMODE-LASERLICHTQUELLE**
METHOD FOR CONNECTING A COLLIMATING OPTICS UNIT WITH A MULTI-MODE LASER LIGHT SOURCE AT AN OPTIMIZED POSITION
PROCÉDÉ DE RACCORDEMENT OPTIMISÉ AU NIVEAU DE LA POSITION D'UNE OPTIQUE DE COLLIMATION DOTÉE D'UNE SOURCE DE LUMIÈRE LASER MULTIMODE

(43) Veröffentlichungstag der Anmeldung: 25.03.2020
(73) Patentinhaber: ZKW Group GmbH, 3250 Wieselburg (AT)
(72) Erfinder: Bissinger, Stephan, 2700 Wr. Neustadt (AT); Hieger, Christof, 3142 Perschling (AT)
(74) Vertreter: Patentanwaltskanzlei Matschnig & Forsthuber OG

(56) Entgegenhaltungen:
- DE-A1-102011 005 014
- US-A1- 2002 012 506
- US-A1- 2008 050 151

## Beschreibung

Die Erfindung betrifft ein Verfahren zum positionsoptimierten Verbinden einer Kollimationsoptik mit einer Multimode-Laserlichtquelle. Als Multimode-Laserlichtquellen seien an dieser Stelle beispielsweise Laserdioden mit der Modellbezeichnung PL 450B oder PL TB450B des Unternehmens OSRAM erwähnt.

Zudem betrifft die Erfindung ein Lichtmodul mit zumindest einer Multimoden-Laserlichtquelle und je einer der zumindest einen Multimoden-Laserlichtquelle zugeordneten Kollimationsoptik, wobei die Kollimationsoptik in Bezug auf die Laserlichtquelle erfindungsgemäß in einer optimierten Endposition positionsstabil fixiert ist.

Außerdem betrifft die Erfindung einen Fahrzeugscheinwerfer, insbesondere einen Kraftfahrzeugscheinwerfer, mit zumindest einem erfindungsgemäßen Lichtmodul.

Aus dem Stand der Technik sind diverse Verfahren zur positionsstabilen Verbindung von Lichtquellen an einem Träger bekannt geworden. Beispielsweise ist aus der WO 2016/197166 A1 ein Verfahren zur Bestückung eines Schaltungsträgers mit Lichtquellen, insbesondere LED-Lichtquellen, bekannt geworden.

Für die Verwendung von Laserlichtquellen werden diese regelmäßig mit einer Kollimatoroptik versehen, die das von der Laserlichtquelle abgestrahlte Licht kollimiert, das nachfolgend beispielsweise auf ein Konvertermaterial, z.B. einen Phosphor, gelenkt wird, um das Laserlicht in einen für das menschliche Auge sichtbaren Wellenlängenbereich zu wandeln.

Die Positionierung der Kollimatoroptik in Bezug auf die Laserlichtquelle ist für das möglichst genaue Erreichen einer gewünschten Lichtverteilung wesentlich. Positionsungenauigkeiten haben Abweichungen von der gewünschten Lichtverteilung zur Folge.

Ein positionsoptimiertes Verfahren zur Positionierung und nachfolgenden Befestigung einer Kollimationsoptik relativ zu einem Laser ist aus US 2002/0012506 A1, US 2008/0050151 A1 und DE 10 2011 005 014 A1 bekannt.

Eine Aufgabe der Erfindung besteht daher darin, ein Verfahren zum positionsoptimierten Verbinden einer Kollimationsoptik mit einer Multimode-Laserlichtquelle zu schaffen, das die zuvor genannten Nachteile überwindet.

Diese Aufgabe wird mit einem Verfahren der eingangs genannten Art gelöst, welches erfindungsgemäß die folgenden Schritte umfasst:
a) Aktivieren der Laserlichtquelle zur Abstrahlung von Laserlicht,
b) Heranführen der Kollimationsoptik an die Laserlichtquelle hin zu einer vorgebbaren ersten Position, wobei die erste Position dergestalt gewählt ist, dass aus der Laserlichtquelle austretendes Laserlicht in die Kollimationsoptik eintritt,
c) Verbessern der ersten Position der Kollimationsoptik hin zu einer optimierten Endposition unter Ausführung der Teilschritte c1) bis c3), wobei in diesen Teilschritten c1) bis c3) jeweils
   eine der aktuellen Ist-Position der Kollimationsoptik zugeordnete durch die Kollimationsoptik abgestrahlte Ist-Laserlichtverteilung erfasst und mit einer vorgebbaren Soll-Laserlichtverteilung verglichen wird, wobei die Soll-Laserlichtverteilung einer Soll-Position der Kollimationsoptik zugeordnet ist, wobei die Ist-Position der Kollimationsoptik iterativ an die Soll-Position angenähert wird, indem die Ist-Position ergebnisabhängig von einem Vergleich der Ist-Laserlichtverteilung mit der Soll-Laserlichtverteilung verändert wird, wobei die Teilschritte c1) bis c3) wie folgt ausgeführt werden:
   c1) Vergleichen der der ersten Position zugeordneten Ist-Laserlichtverteilung mit der Soll-Laserlichtverteilung und ergebnisabhängiges Ändern der ersten Position bis ein vorgebbares erstes Übereinstimmungskriterium mit der Soll-Laserlichtverteilung erzielt wird, wobei dadurch eine grobjustierte verbesserte zweite Position der Kollimationsoptik erhalten wird,
      wobei die Änderung der Position der Kollimationsoptik ausschließlich innerhalb einer Ebene erfolgt, die durch normal zueinander orientierte Achsen x und y aufgespannt wird, wobei diese Ebene normal zur optischen Achse der Laserlichtquelle orientiert ist,
   c2) Vergleichen der der grobjustierten verbesserten zweiten Position zugeordneten Ist-Laserlichtverteilung mit der Soll-Laserlichtverteilung und ergebnisabhängiges Ändern der zweiten Position ausschließlich in Richtung einer zu den Achsen x und y normal orientierten dritten Achse z, bis ein vorgebbares zweites Übereinstimmungskriterium mit der Soll-Laserlichtverteilung erzielt wird, wobei dadurch eine grobjustierte verbesserte dritte Position der Kollimationsoptik erhalten wird,
   c3) Vergleichen der der grobjustierten verbesserten dritten Position zugeordneten Ist-Laserlichtverteilung mit der Soll-Laserlichtverteilung und ergebnisabhängiges Ändern der dritten Position in Richtung der x-,y- und z-Richtung bis ein vorgebbares drittes Übereinstimmungskriterium mit der Soll-Laserlichtverteilung erzielt wird, wobei dadurch die optimierte Endposition erhalten wird,
d) Herstellen einer positionsstabilen Verbindung zur Fixierung der Kollimationsoptik in Bezug auf die Laserlichtquelle in der optimierten Endposition.

Die vorhergehende Vorabpositionierung in den Schritten c1) und c2) führt zu einer Ist-Lichtverteilung, die der Soll-Lichtverteilung bereits angenähert ist und charakteristische Merkmale, die der Soll-Lichtverteilung zugeordnet sind, bereits zu einem gewissen Ausmaß aufweist. Basierend darauf lässt sich im Schritt c3) eine Feinjustierung effizient vornehmen. In Schritt c3) kann es zudem zweckmäßig sein, die Schrittweite bei Änderungen der Position in x- y- oder z-Richtung gegenüber der Schrittweite der vorhergehenden Schritte c1) und c2) zu reduzieren.

Bei dem Verbessern der ersten Position sind z.B. Winkelabweichungen von ca. 1° möglich und die Position in Z-Richtung ist zu diesem Zeitpunkt noch nicht optimiert. Die Analyse der Lage in x- und y- Richtung ist in dieser defokussierten Stellung einfacher. Die Lichtquellen können über Referenzpunkte verfügen, anhand derer Orientierung festlegbar ist (typischerweise mechanische Anschläge, sodass in diese exakt in einem Greifer oder Kühlkörper positioniert werden können).

Insbesondere kann vorgesehen sein, dass das erste Übereinstimmungskriterium gemäß Teilschritt c1) die Übereinstimmung der Lage der Maxima von x- und y- Verteilung in Bezug auf die optische Achse der Kollimationsoptik betrifft. Dies stellt einen Justageschritt zur Ausrichtung der Linse über der Laserachse dar. Damit kann die Justagezeit minimiert werden, da große Laserspots generiert werden, die einfach erfasst werden können. Vorzugsweise wird die Laserlichtquelle dabei so orientiert, dass Achsen der Quelle mit den Achsen des Sensors zusammenfallen.

Zudem kann vorgesehen sein, dass das zweite Übereinstimmungskriterium gemäß Teilschritt c2) die Ausbildung einer charakteristischen Laserlichtverteilung in Richtung der Fast-Axis der Laserlichtquelle betrifft. Dies stellt einen zweiten Justageschritt zur Ermittlung des Fokuspunktes der Linse (Toleranzabhängig, Diode, Linse) dar. Das dritte Übereinstimmungskriterium gemäß Teilschritt c3) könnte einerseits einfach in einer Erhöhung der Schwelle gemäß dem ersten und/oder dem zweiten Kriterium liegen, andererseits könnten diese Kriterien ebenso kombiniert werden oder neue Kriterien geschaffen werden. Insbesondere kann vorgesehen sein, dass in Teilschritten c3) die Lage in x-, y- und/oder z-Verteilung in mit im Vergleich zu den Teilschritten c1) und c2) reduzierten Schrittweiten weiter optimiert wird. Auf beispielhafte Kriterien wird in der nachfolgenden Figurenbeschreibung näher eingegangen.

Insbesondere ist vorgesehen, dass in Teilschritt c3) zudem die Orientierung der Kollimationsoptik durch Drehen der Kollimationsoptik um die x-Achse verändert wird. Zudem ist vorgesehen, dass in Teilschritt c3) zudem die Orientierung der Kollimationsoptik durch Drehen der Kollimationsoptik um die y-Achse verändert wird. Auf diese Weise kann die Orientierung der Kollimationsoptik optimiert werden.

Zudem kann vorgesehen sein, dass die Laserlichtquelle in einem metallischen Kühlkörper formschlüssig aufgenommen ist. Auf diese Weise kann die Kühlung der Laserlichtquelle verbessert werden. Gleichzeitig wird damit sichergestellt, dass die Position der Laserlichtquelle fixiert ist und eine Positionierung weiterer Komponenten wie beispielsweise der Kollimationsoptik in Bezug auf die Laserlichtquelle durch Referenzieren und/oder Verbinden mit dem Kühlkörper erfolgt. Unter dem Ausdruck "formschlüssig aufgenommen" wird eine Anordnung verstanden, in der das jeweilige Element seitlich umschlossen ist, sodass dieses stabil gehalten wird. Die optisch relevanten Flächen, wie z.B. die Lichtaustrittsfläche der Laserlichtquelle und/oder die Eintritts- und Austrittsfläche der Kollimatoroptik sind dabei nicht verdeckt.

Vorteilhafterweise kann vorgesehen sein, dass die Kollimationsoptik in einem metallischen Träger formschlüssig aufgenommen und fixiert ist. Dabei kann insbesondere vorgesehen sein, dass die positionsstabile Verbindung gemäß Schritt d) durch Herstellen zumindest einer Laserschweißverbindung zwischen dem metallischen Kühlkörper und dem metallischen Träger ausgebildet wird. Der Einsatz von Laserschweißen ist in diesem Zusammenhang aufgrund der hohen Positionsgenauigkeit sowie der kurzen Bearbeitungszeitdauer von Vorteil. Die Kollimationsoptik kann während der Zeitdauer des Laserschweißvorganges, der beispielsweise zwischen 4 und 10 Sekunden beträgt, durch einen Roboterarm in ihrer Position festgehalten werden. Ein etwaiges Verziehen der Verbindung aufgrund des Aushärtungsvorganges wird vermieden.

Alternativ oder ergänzend dazu kann vorgesehen sein, dass die positionsstabile Verbindung in Schritt d) durch Kleben hergestellt wird. Dabei kann insbesondere vorgesehen sein, dass der Klebstoff ein UV-härtender Klebstoff ist, der in Schritt d) zum Herstellen der positionsstabilen Verbindung mit UV-Licht beleuchtet wird.

Um einen durch den Aushärtungsvorgang bedingten ungleichmäßigen Versatz der Kollimationsoptik entgegen zu wirken, kann vorgesehen sein, dass zur Herstellung der positionsstabilen Verbindung gemäß Schritt d) eingesetzten Verbindungsmittel (also beispielsweise eine Schweiß- und/oder Klebeverbindung der genannten Art) symmetrisch um die optische Achse der Laserlichtquelle angeordnet sind.

Die Erfindung ist im Folgenden anhand einer beispielhaften und nicht einschränkenden Ausführungsform näher erläutert, die in den Figuren veranschaulicht ist. Darin zeigt
Figur 1 eine schematische Darstellung eines Lichtmoduls, wobei eine darin dargestellte Kollimationsoptik an eine Laserlichtquelle herangeführt wird, wobei sich die Kollimationsoptik in einer Ausgangsposition befindet,
Figur 2 das Lichtmodul gemäß Figur 1, wobei sich die Kollimationsoptik in einer zweiten Position befindet,
Figur 3 das Lichtmodul gemäß Figuren 1 und 2, wobei sich die Kollimationsoptik in einer dritten Position befindet,
Figur 4 das Lichtmodul gemäß Figuren 1 bis 3, wobei sich die Kollimationsoptik in einer Endposition befindet,
Figur 5 das Lichtmodul gemäß Figuren 1 bis 4, wobei die Kollimationsoptik mit der Laserlichtquelle fest verbunden ist,
Figur 6a und 6b beispielhafte Lichtverteilungen des durch die Kollimationsoptik abgestrahlten Lichts,
Figuren 7a bis 7e weitere beispielhafte Lichtverteilungen des durch die Kollimationsoptik abgestrahlten Lichts.

In den folgenden Figuren bezeichnen - sofern nicht anders angegeben - gleiche Bezugszeichen gleiche Merkmale.

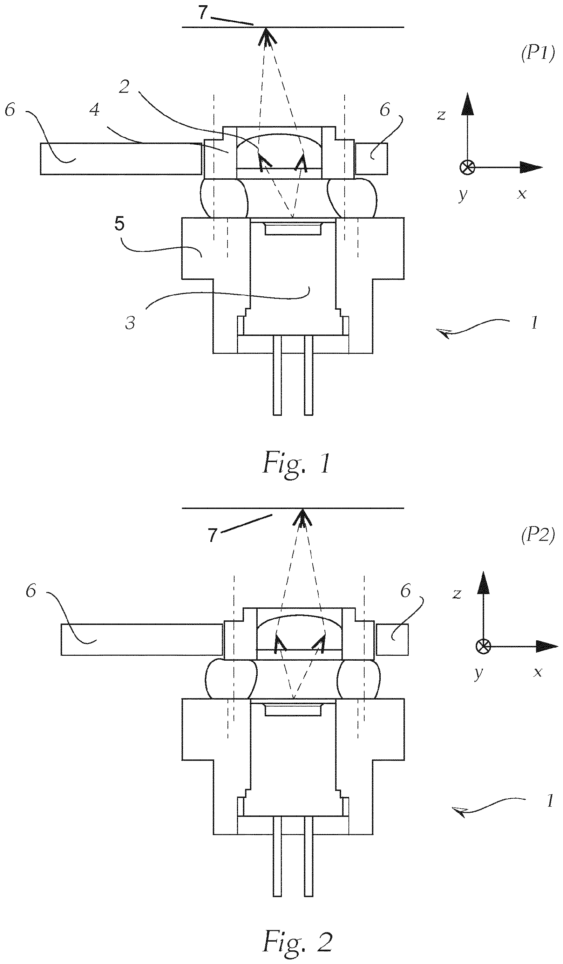

Figur 1 zeigt eine schematische Darstellung eines Lichtmoduls 1, das eine Kollimationsoptik 2 und eine Laserlichtquelle 3 umfasst. Die Kollimationsoptik 2, die beispielsweise als Linse ausgebildet sein kann, befindet sich in einer Ausgangsposition, die im Folgenden als erste Position P1 bezeichnet wird. Die Kollimationsoptik 2 ist dabei formschlüssig in einem Linsenhalter 4 gehalten. Die Laserlichtquelle 3 ist formschlüssig in einem Kühlkörper 5 aufgenommen.

Ein Greifarm 6 eines Positioniervorrichtung, insbesondere eines Roboters, greift an dem Linsenhalter 4 an und hält diesen in seiner Position fest. Bei der Positioniervorrichtung kann es sich beispielsweise um einen Hybrid-Hexapod-Roboter handeln, der beispielsweise eine Auflösung von 100nm aufweist.

Die erste Position P1 ist dabei so gewählt, dass Licht, das von der Laserlichtquelle 3 abgestrahlt werden kann, durch die Kollimationsoptik hindurch tritt und auf einen senkrecht oberhalb der Laserlichtquelle angeordneten Sensor 7 auftrifft, der zur Erfassung des Laserlichts eingerichtet ist.

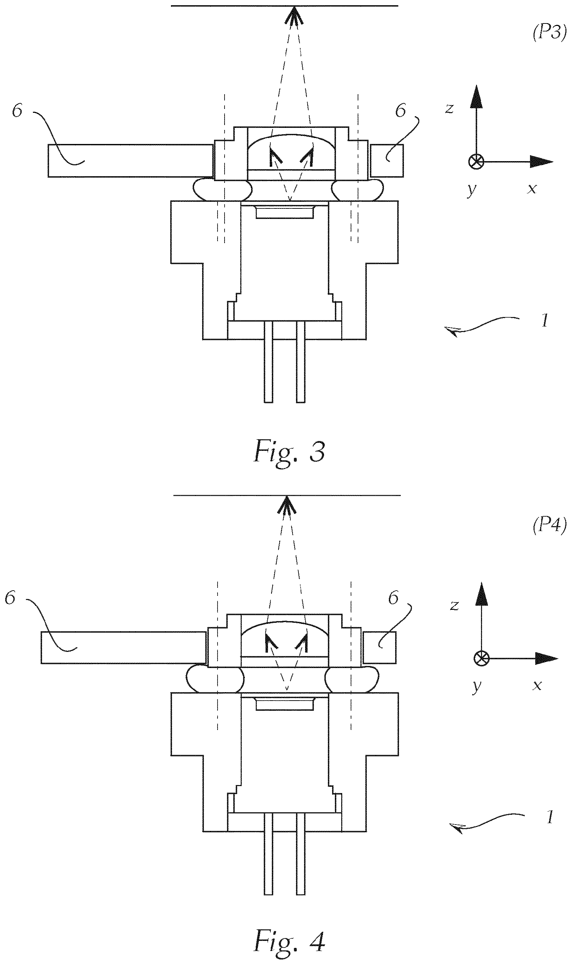

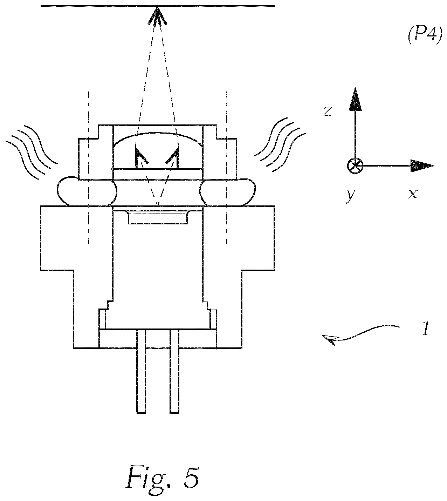

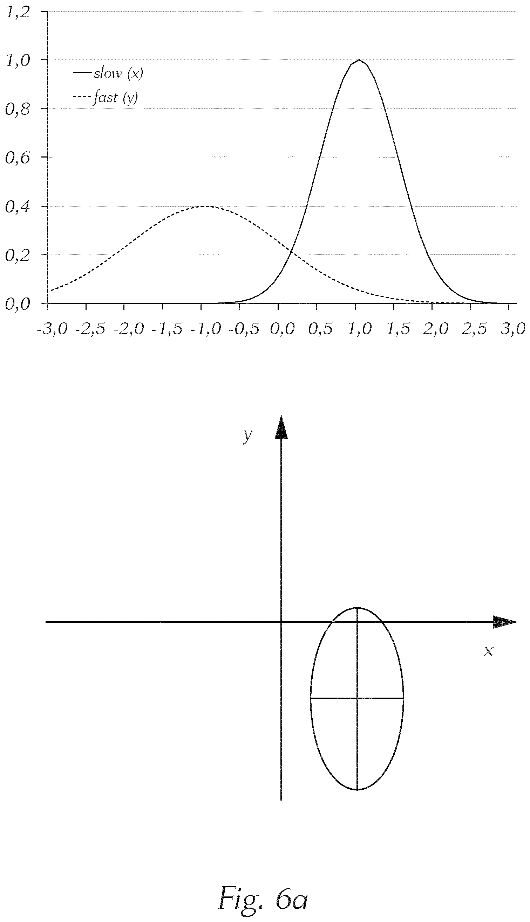

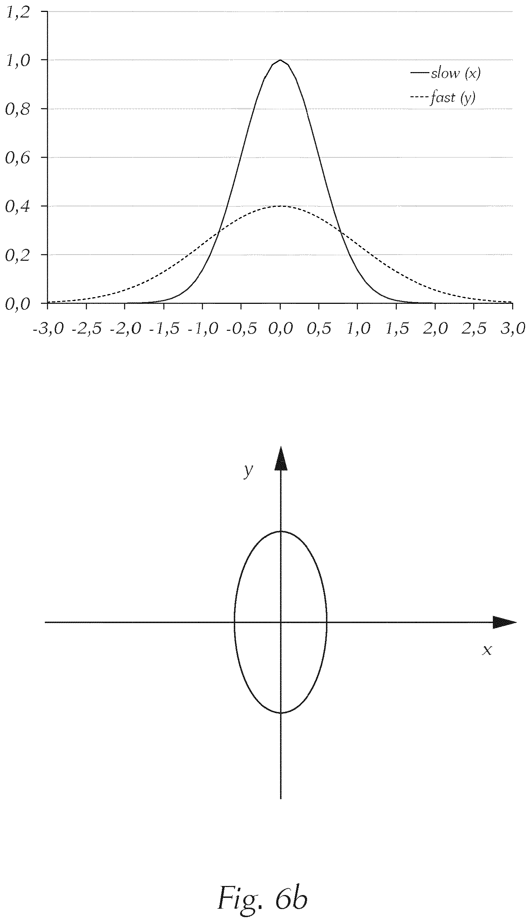

Im Folgenden wird anhand der Figuren 1 bis 5 ein Ausführungsbeispiel eines erfindungsgemäßen Optimierungsverfahren ausgehend von der Position P1 gemäß Figur 1 und zur Fixierung einer verbesserten Position erörtert, wobei zur besseren Übersicht Bezugszeichen in den Figuren 2 bis 5 weitgehend weggelassen wurden:
Dieses Verfahren umfasst die folgenden Schritte:
a) Aktivieren der Laserlichtquelle 3 zur Abstrahlung von Laserlicht,
b) Heranführen der Kollimationsoptik 2 an die Laserlichtquelle 3 hin zu einer vorgebbaren ersten Position P1, wobei die erste Position P1 dergestalt gewählt ist, dass aus der Laserlichtquelle 3 austretendes Laserlicht 3 in die Kollimationsoptik 2 eintritt,
c) Verbessern der ersten Position P1 der Kollimationsoptik 2 hin zu einer optimierten Endposition P4 (siehe Figuren 4 und 5) unter Ausführung der Teilschritte c1) bis c3), wobei in diesen Teilschritten c1) bis c3) jeweils
   eine der aktuellen Ist-Position der Kollimationsoptik 2 zugeordnete durch die Kollimationsoptik 2 abgestrahlte Ist-Laserlichtverteilung (siehe beispielsweise Fig. 6a) erfasst und mit einer vorgebbaren Soll-Laserlichtverteilung (siehe Fig. 6b) verglichen wird, wobei die Soll-Laserlichtverteilung einer Soll-Position der Kollimationsoptik 2 zugeordnet ist, wobei die Ist-Position der Kollimationsoptik 2 iterativ an die Soll-Position angenähert wird, indem die Ist-Position ergebnisabhängig von einem Vergleich der Ist-Laserlichtverteilung mit der Soll-Laserlichtverteilung verändert wird, wobei die Teilschritte c1) bis c3) wie folgt ausgeführt werden:
   c1) Vergleichen der der ersten Position P1 zugeordneten Ist-Laserlichtverteilung mit der Soll-Laserlichtverteilung und ergebnisabhängiges Ändern der ersten Position P1 bis ein vorgebbares erstes Übereinstimmungskriterium (beispielsweise grobe Übereinstimmung der Lage der Maxima der Laserlichtverteilung in x- und y- Richtung, wobei als Ursprung der Schnittpunkt der optischen Achse der Laserlichtquelle 3 mit einer Normalebene herangezogen werden kann, wobei die Normalebene durch die Achsen x und y aufgespannt wird) mit der Soll-Laserlichtverteilung erzielt wird, wobei dadurch eine grobjustierte verbesserte zweite Position P2 der Kollimationsoptik 2 erhalten wird (siehe Figur 2),
      wobei die Änderung der Position der Kollimationsoptik 2 ausschließlich innerhalb einer Ebene erfolgt, die durch normal zueinander orientierte Achsen x und y aufgespannt wird, wobei diese Ebene normal zur optischen Achse der Laserlichtquelle 3 orientiert ist,
   c2) Vergleichen der der grobjustierten verbesserten zweiten Position P2 zugeordneten Ist-Laserlichtverteilung mit der Soll-Laserlichtverteilung und ergebnisabhängiges Ändern der zweiten Position P2 ausschließlich in Richtung einer zu den Achsen x und y normal orientierten dritten Achse z, bis ein vorgebbares zweites Übereinstimmungskriterium mit der Soll-Laserlichtverteilung erzielt wird, wobei dadurch eine grobjustierte verbesserte dritte Position P3 der Kollimationsoptik 2 erhalten wird (siehe Figur 3),
   c3) Vergleichen der der grobjustierten verbesserten dritten Position P3 zugeordneten Ist-Laserlichtverteilung mit der Soll-Laserlichtverteilung und ergebnisabhängiges Ändern der dritten Position P3 in Richtung der x-,y- und z-Richtung bis ein vorgebbares drittes Übereinstimmungskriterium mit der Soll-Laserlichtverteilung erzielt wird, wobei dadurch die optimierte Endposition 4 (siehe Figur 4) erhalten wird,
d) Herstellen einer positionsstabilen Verbindung zur Fixierung der Kollimationsoptik 2 in Bezug auf die Laserlichtquelle 3 in der optimierten Endposition P4 (siehe Figur 5), wobei im vorliegenden Ausführungsbeispiel die Verbindung mittels Klebeverbindung hergestellt ist, die in der Endposition gemäß Fig. 5 aushärtet (z.B. durch UV-Bestrahlung). Das hierfür eingesetzte Klebematerial wird vorzugsweise bereits zu Beginn der Positionierung (siehe Position P1) angebracht, sodass eine ausreichende Menge an Klebematerial aufgebracht und eine im Endzustand dauerhafte Verbindung sichergestellt werden kann. Die Klebeverbindung ist in den Figuren 1 bis 5 rein schematisch dargestellt und weicht in der Praxis von den dargestellten Proportionen ab.

Das Erfassen der Laserlichtverteilungen kann z.B. durch Messen der Intensität des Laserlichts erfolgen.

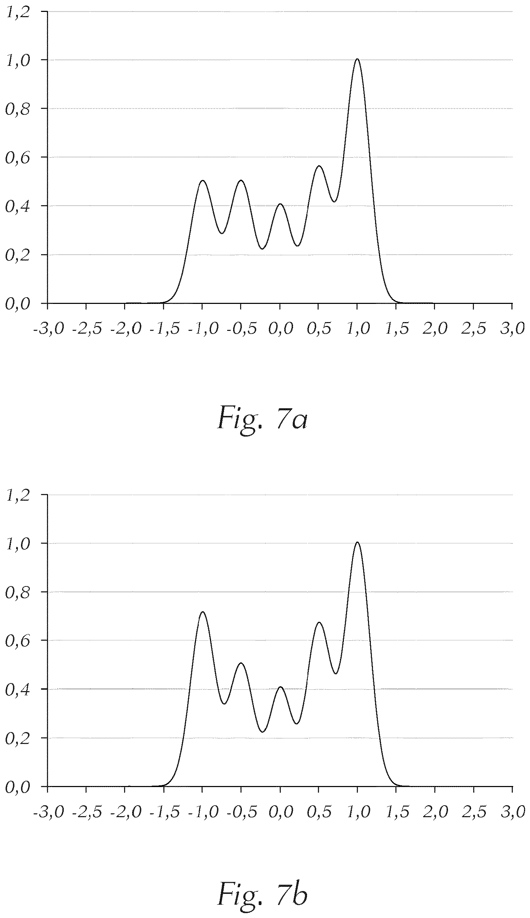

Figur 7a und 7b zeigen weitere beispielhafte Lichtverteilungen des durch die Kollimationsoptik abgestrahlten Lichts.

Im Folgend werden beispielhaft Kriterien zur Bestimmung der Überstimmung von Ist-Verteilungen mit der Soll-Verteilung des Laserlichts beschrieben.

### Zu Schritt C1)

Die Ist-Laserverteilung stellt einen Schnitt durch den vermessenen Laserspot dar. Die Güte der Justage wird durch die Abweichung der beiden Maxima zueinander gegeben und ist ein proportionales Maß für den Justageweg des Roboters.

Die Soll-Laserlichtverteilung wird durch bestmögliche überlagern der Maxima der Kurven für slow(X) and fast(y) axis erreicht (siehe Fig. 6a). Für die erste Justage sollen die beiden Maxima innerhalb eines Intervalls der Größe von etwa 10% der Halbwärtsbreite der Slowaxis (x-Kurve) zu liegen kommen (siehe Fig. 6b).

### Zu Schritt C2)

Justage normal zur x-y Achse der Linse führt zu einer charakteristischen Laserspotverteilung, abhängig von dem Typ der Laserdiode (siehe Fig. 7a). Bei Erreichen der gewünschten Endlage stellt sich Charakteristika des Laserspot ein (siehe Fig. 7b). Für eine Multimodendiode Beispielhalft ausgeführt, ein Intensitätsplateau mit lokalen Minima und Maxima, eingeschlossen von zwei Seitenmaxima.

### Zu Schritt C3)

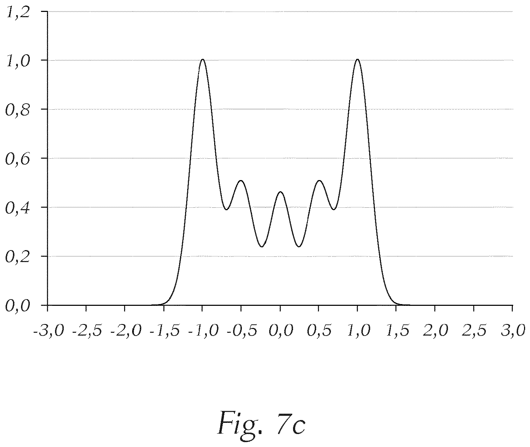

Die Breite der Kurve stellt das Maß für die z Justage dar. Abweichung in + oder - führt zu einer Verbreitung oder Verjüngung der Kurve als Ganzes. Die Lage der Linse in y (Fast-Axes) und Winkel b wird durch die Höhe der beiden Seitenmaxima, und der inneren lokalen Maxima und Minima beschrieben. Die Differenz der seitlichen Maxima gibt ein direktes Maß für den Justage Weg der y Achse, die Höhendifferenz sollte <5% betragen. Je nach gewünschter Güte des Lasers und möglicher Justagezeit ist die Höhendifferenz zu wählen. Der Winkel a nimmt geringeren Einfluß auf die Höhendifferenz, nimmt aber dennoch Einfluss auf die inneren lokalen Extremstellen. Die geringsten Höhendifferenzen der Maxima zueinander und der Minima zueinander zeigt die beste Justagelage an (siehe Fig. 7c).

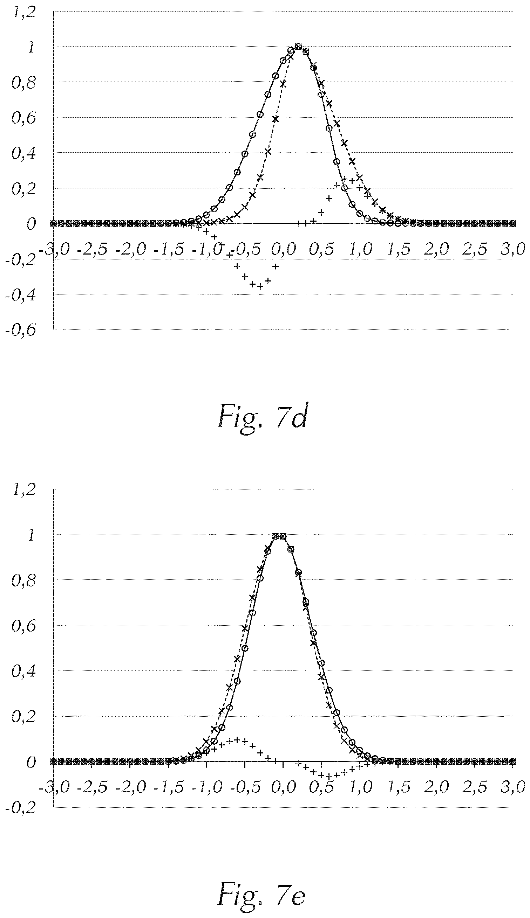

Die Justage in x (Slow-Axes) und a erfolgt durch den Vergleich der zweiten Intensitätskurve. Durch einen Vergleich einer gefitteten Gaußkurve (Kreise) mit dem Ist-Laserspot (X-Punkte) wird die optimale Lage bestimmt. Die Subtraktion der beiden Kurven (Kreuze) ergibt ein Maß für die Abweichung und der Orientierung der Abweichung. Bei Versatz in +x entsteht ein Maximum bei der fallenden Intensitätsflanke des Laserspots, bei Versatz in -x ein Minimum. Auf der ansteigenden Flanke des Spots verhalten sich die Max. und Min. umgekehrt. Die Höhe des Maximums, bzw. Minimums gibt das Maß für den Justageweg. Die Höhe des Differenz-Maximums\Minimums sollte kleiner als 5% des Hauptmaximums unterschreiten\überschreiten. Je nach gewünschter Güte des Lasers und möglicher Justagezeit ist die Extremwerthöhe zu wählen (siehe Fig. 7d und 7e).

## Patentansprüche

1. Verfahren zum positionsoptimierten Verbinden einer Kollimationsoptik (2) mit einer Multimode-Laserlichtquelle (3), umfassend die folgenden Schritte:
a) Aktivieren der Laserlichtquelle (3) zur Abstrahlung von Laserlicht,
b) Heranführen der Kollimationsoptik (2) an die Laserlichtquelle (3) hin zu einer vorgebbaren ersten Position (P1), wobei die erste Position (P1) dergestalt gewählt ist, dass aus der Laserlichtquelle (3) austretendes Laserlicht in die Kollimationsoptik (2) eintritt,
c) Verbessern der ersten Position (P1) der Kollimationsoptik (2) hin zu einer optimierten Endposition unter Ausführung der Teilschritte c1) bis c3), wobei in diesen Teilschritten c1) bis c3) jeweils
eine der aktuellen Ist-Position der Kollimationsoptik (2) zugeordnete durch die Kollimationsoptik (2) abgestrahlte Ist-Laserlichtverteilung erfasst und mit einer vorgebbaren Soll-Laserlichtverteilung verglichen wird, wobei die Soll-Laserlichtverteilung einer Soll-Position der Kollimationsoptik (2) zugeordnet ist, wobei die Ist-Position der Kollimationsoptik (2) iterativ an die Soll-Position angenähert wird, indem die Ist-Position ergebnisabhängig von einem Vergleich der Ist-Laserlichtverteilung mit der Soll-Laserlichtverteilung verändert wird, wobei die Teilschritte c1) bis c3) wie folgt ausgeführt werden:
c1) Vergleichen der der ersten Position (P1) zugeordneten Ist-Laserlichtverteilung mit der Soll-Laserlichtverteilung und ergebnisabhängiges Ändern der ersten Position (P1) bis ein vorgebbares erstes Übereinstimmungskriterium mit der Soll-Laserlichtverteilung erzielt wird, wobei dadurch eine grobjustierte verbesserte zweite Position (P2) der Kollimationsoptik (2) erhalten wird,
wobei die Änderung der Position der Kollimationsoptik (2) ausschließlich innerhalb einer Ebene erfolgt, die durch normal zueinander orientierte Achsen x und y aufgespannt wird, wobei diese Ebene normal zur optischen Achse der Laserlichtquelle (3) orientiert ist,
c2) Vergleichen der der grobjustierten verbesserten zweiten Position (P2) zugeordneten Ist-Laserlichtverteilung mit der Soll-Laserlichtverteilung und ergebnisabhängiges Ändern der zweiten Position (P2) ausschließlich in Richtung einer zu den Achsen x und y normal orientierten dritten Achse z, bis ein vorgebbares zweites Übereinstimmungskriterium mit der Soll-Laserlichtverteilung erzielt wird, wobei dadurch eine grobjustierte verbesserte dritte Position (P3) der Kollimationsoptik (2) erhalten wird,
c3) Vergleichen der der grobjustierten verbesserten dritten Position (P3) zugeordneten Ist-Laserlichtverteilung mit der Soll-Laserlichtverteilung und ergebnisabhängiges Ändern der dritten Position (P3) in Richtung der x-,y- und z-Richtung bis ein vorgebbares drittes Übereinstimmungskriterium mit der Soll-Laserlichtverteilung erzielt wird, wobei dadurch die optimierte Endposition (4) erhalten wird,
d) Herstellen einer positionsstabilen Verbindung zur Fixierung der Kollimationsoptik (2) in Bezug auf die Laserlichtquelle (3) in der optimierten Endposition,
**dadurch gekennzeichnet, dass**
in Teilschritt c3) zudem die Orientierung der Kollimationsoptik (2) durch Drehen der Kollimationsoptik (2) um die x-Achse verändert wird, wobei in Teilschritt c3) zudem die Orientierung der Kollimationsoptik (2) durch Drehen der Kollimationsoptik (2) um y-Achse verändert wird.

2. Verfahren nach Anspruch 1, wobei das erste Übereinstimmungskriterium gemäß Teilschritt c1) die Übereinstimmung der Lage der Maxima von x- und y- Verteilung in Bezug auf die optische Achse der Kollimationsoptik (2) betrifft.

3. Verfahren nach Anspruch 1 oder 2, wobei das zweite Übereinstimmungskriterium gemäß Teilschritt c2) die Ausbildung einer charakteristischen Laserlichtverteilung in Richtung der Fast-Axis der Laserlichtquelle (3) betrifft.

4. Verfahren nach einem der vorhergehenden Ansprüche, wobei das dritte Übereinstimmungskriterium gemäß Teilschritt c3) darin besteht, die Lage in x-, y- und/oder z-Verteilung in mit im Vergleich zu den Teilschritten c1) und c2) reduzierten Schrittweiten weiter optimiert wird, wobei die Übereinstimmungskriterien nach Schritten c1) und/oder c2) herangezogen werden.

5. Verfahren nach einem der vorhergehenden Ansprüche, wobei die Laserlichtquelle (3) in einem metallischen Kühlkörper (5) formschlüssig aufgenommen ist.

6. Verfahren nach einem der vorhergehenden Ansprüche, wobei die Kollimationsoptik (2) in einem metallischen Träger (4) formschlüssig aufgenommen und fixiert ist.

7. Verfahren nach Anspruch 5 und 6, wobei die positionsstabile Verbindung gemäß Schritt d) durch Herstellen zumindest einer Laserschweißverbindung zwischen dem metallischen Kühlkörper (5) und dem metallischen Träger (4) ausgebildet wird.

8. Verfahren nach einem der vorhergehenden Ansprüche, wobei die positionsstabile Verbindung in Schritt d) durch Kleben hergestellt wird.

9. Verfahren nach Anspruch 8, wobei der Klebstoff ein UV-härtender Klebstoff ist, der in Schritt d) zum Herstellen der positionsstabilen Verbindung mit UV-Licht beleuchtet wird.

10. Verfahren nach einem der vorhergehenden Ansprüche, wobei die zur Herstellung der positionsstabilen Verbindung gemäß Schritt d) eingesetzten Verbindungsmittel symmetrisch um die optische Achse der Laserlichtquelle (3) angeordnet sind.

## Claims

1. Method for the position-optimized connection of a collimating optics (2) to a multimode laser light source (3), comprising the following steps:
a) activating the laser light source (3) to emit laser light,
b) bringing the collimation optics (2) up to the laser light source (3) to a predeterminable first position (PI), the first position (P1) being selected in such a way that laser light emerging from the laser light source (3) enters the collimation optics (2),
c) improving the first position (P1) of the collimation optics (2) towards an optimized final position by carrying out sub-steps c1) to c3), wherein in these sub-steps c1) to c3) in each case an actual laser light distribution assigned to the current actual position of the collimation optics (2) and radiated by the collimation optics (2) is detected and compared with a predeterminable desired laser light distribution, the desired laser light distribution being assigned to a desired position of the collimation optics (2), wherein the actual position of the collimation optics (2) is iteratively approximated to the desired position by changing the actual position in dependence on a comparison of the actual laser light distribution with the desired laser light distribution, wherein the partial steps c1) to c3) are carried out as follows:
c1) comparing the actual laser light distribution assigned to the first position (P1) with the desired laser light distribution and changing the first position (P1) in a result-dependent manner until a predeterminable first criterion of agreement with the desired laser light distribution is achieved, a roughly adjusted improved second position (P2) of the collimation optics (2) being obtained as a result,
wherein the change in the position of the collimation optics (2) takes place exclusively within a plane which is spanned by axes x and y oriented normal to one another, this plane being oriented normal to the optical axis of the laser light source (3),
c2) comparing the actual laser light distribution associated with the coarsely adjusted improved second position (P2) with the desired laser light distribution and changing the second position (P2) in dependence on the result exclusively in the direction of a third axis z oriented normally to the axes x and y until a predeterminable second criterion of conformity with the desired laser light distribution is achieved, a coarsely adjusted improved third position (P3) of the collimation optics (2) being obtained as a result,
c3) comparing the actual laser light distribution associated with the coarsely adjusted improved third position (P3) with the desired laser light distribution and changing the third position (P3) in the direction of the x, y and z direction in dependence on the result until a predeterminable third criterion of conformity with the desired laser light distribution is achieved, the optimized end position (4) being obtained as a result,
d) producing a positionally stable connection for fixing the collimation optics (2) with respect to the laser light source (3) in the optimized end position, **characterized in that**
in sub-step c3) the orientation of the collimation optics (2) is also changed by rotating the collimation optics (2) about the x-axis, whereby in sub-step c3) the orientation of the collimation optics (2) is also changed by rotating the collimation optics (2) about the y-axis.

2. Method according to claim 1, wherein the first criterion of agreement according to substep c1) concerns the agreement of the position of the maxima of x- and y- distribution with respect to the optical axis of the collimation optics (2).

3. Method according to claim 1 or 2, wherein the second matching criterion according to substep c2) concerns the formation of a characteristic laser light distribution in the direction of the fast axis of the laser light source (3).

4. Method according to one of the preceding claims, wherein the third matching criterion according to substep c3) consists in further optimizing the position in x, y and/or z distribution in step widths reduced in comparison with substeps c1) and c2), wherein the matching criteria according to steps c1) and/or c2) are used.

5. Method according to one of the preceding claims, wherein the laser light source (3) is positively accommodated in a metallic heat sink (5).

6. Method according to one of the preceding claims, wherein the collimation optics (2) is positively received and fixed in a metallic carrier (4).

7. Method according to claims 5 and 6, wherein the positionally stable connection according to step d) is formed by producing at least one laser welded connection between the metallic heat sink (5) and the metallic carrier (4).

8. Method according to any of the preceding claims, wherein the positionally stable connection in step d) is formed by adhesive bonding.

9. Method according to claim 8, wherein the adhesive is a UV-curing adhesive which is illuminated with UV light in step d) to produce the positionally stable bond.

10. Method according to one of the preceding claims, wherein the joining means used to produce the positionally stable joint according to step d) are arranged symmetrically about the optical axis of the laser light source (3).

## Revendications

1. Méthode pour la connexion optimisée en position d'une optique de collimation (2) à une source de lumière laser multimode (3), comprenant les étapes suivantes :
a) en activant la source de lumière laser (3) pour émettre de la lumière laser,
b) amener l'optique de collimation (2) jusqu'à la source de lumière laser (3) dans une première position (P1) pouvant être prédéterminée, la première position (P1) étant choisie de telle sorte que la lumière laser sortant de la source de lumière laser (3) pénètre dans l'optique de collimation (2),
c) amélioration de la première position (P1) de l'optique de collimation (2) vers une position finale optimisée par l'exécution des sous-étapes c1) à c3), dans lesquelles dans ces sous-étapes c1) à c3) dans chaque cas
une répartition réelle de la lumière laser affectée à la position réelle actuelle de l'optique de collimation (2) et rayonnée par l'optique de collimation (2) est détectée et comparée à une répartition de lumière laser souhaitée pouvant être prédéterminée, la répartition de lumière laser souhaitée étant affectée à une position souhaitée de l'optique de collimation (2), dans lequel la position réelle de l'optique de collimation (2) est approchée itérativement de la position souhaitée en modifiant la position réelle en fonction d'une comparaison de la répartition réelle de la lumière laser avec la répartition souhaitée de la lumière laser, les étapes partielles c1) à c3) étant réalisées comme suit :
c1) comparer la répartition réelle de la lumière laser attribuée à la première position (P1) avec la répartition souhaitée de la lumière laser et modifier la première position (P1) en fonction du résultat jusqu'à ce qu'un premier critère d'adaptation prédéterminable avec la répartition souhaitée de la lumière laser soit atteint, ce qui permet d'obtenir une deuxième position (P2) améliorée grossièrement ajustée de l'optique de collimation (2),
dans laquelle le changement de position de l'optique de collimation (2) se fait exclusivement dans un plan qui est couvert par les axes x et y orientés perpendiculairement l'un à l'autre, ce plan étant orienté perpendiculairement à l'axe optique de la source de lumière laser (3),
c2) comparer la répartition réelle de la lumière laser associée à la deuxième position améliorée grossièrement ajustée (P2) avec la répartition souhaitée de la lumière laser et modifier la deuxième position (P2) en fonction du résultat exclusivement dans la direction d'un troisième axe z orienté normalement par rapport aux axes x et y jusqu'à ce qu'un deuxième critère d'adaptation prédéterminable avec la répartition souhaitée de la lumière laser soit atteint, une troisième position améliorée grossièrement ajustée (P3) de l'optique de collimation (2) étant obtenue en conséquence,
c3) comparer la distribution réelle de la lumière laser associée à la troisième position améliorée grossièrement ajustée (P3) avec la distribution de lumière laser souhaitée et modifier la troisième position (P3) dans la direction des directions x, y et z en fonction du résultat jusqu'à ce qu'un troisième critère d'adaptation prédéterminable soit atteint avec la distribution de lumière laser souhaitée, la position finale optimisée (4) étant obtenue en conséquence,
d) réaliser une liaison stable en position pour fixer l'optique de collimation (2) par rapport à la source de lumière laser (3) dans la position finale optimisée, **caractérisé en ce que**
dans la sous-étape c3), l'orientation de l'optique de collimation (2) est également modifiée par rotation de l'optique de collimation (2) autour de l'axe x, où dans la sous-étape c3), l'orientation de l'optique de collimation (2) est également modifiée par rotation de l'optique de collimation (2) autour de l'axe y.

2. Méthode selon la revendication 1, dans lequel le premier critère de concordance selon la sous-étape c1) concerne la concordance de la position des maxima de la distribution x et y par rapport à l'axe optique de l'optique de collimation (2).

3. Méthode selon la revendication 1 ou 2, dans lequel le deuxième critère de correspondance selon la sous-étape c2) concerne la formation d'une distribution caractéristique de la lumière laser dans la direction de l'axe rapide de la source de lumière laser (3).

4. Méthode selon l'une des revendications précédentes, dans laquelle le troisième critère de correspondance selon la sous-étape c3) consiste à optimiser davantage la position dans la distribution x, y et/ ou z dans des largeurs de pas réduites par rapport aux sous-étapes c1) et c2), dans laquelle les critères de correspondance selon les étapes c1) et/ou c2) sont utilisés.

5. Méthode selon l'une des revendications précédentes, dans laquelle la source de lumière laser (3) est logée dans un dissipateur thermique métallique (5) de manière à s'adapter à la forme.

6. Méthode selon l'une des revendications précédentes, dans laquelle l'optique de collimation (2) est reçue positivement et fixée dans un support métallique (4).

7. Méthode selon les revendications 5 et 6, dans laquelle la liaison stable en position selon l'étape d) est formée par la réalisation d'au moins une liaison soudée au laser entre le dissipateur thermique métallique (5) et le support métallique (4).

8. Méthode selon l'une des revendications précédentes, dans lequel la liaison stable en position à l'étape d) est formée par collage.

9. Méthode selon la revendication 8, dans lequel l'adhésif est un adhésif durcissant aux UV qui est éclairé par de la lumière UV à l'étape d) pour produire la liaison stable en position.

10. Méthode selon l'une des revendications précédentes, dans laquelle les moyens d'assemblage utilisés pour produire l'assemblage stable en position selon l'étape d) sont disposés symétriquement autour de l'axe optique de la source de lumière laser (3).
